# EUROPEAN PATENT APPLICATION

(11) **EP 0 949 200 A1**
(43) Date of publication of application: **13.10.1999**
(21) Application number: 97926309.2
(22) Date of filing: 05.06.1997
(51) Int. Cl.: C01B 31/06, C23C 16/26, B05D 3/06

(54) **METHOD FOR FORMING CONFORMAL DIAMOND-TYPE CARBON COATINGS, HARD DIAMOND-TYPE CARBON COATING AND POROUS FILTRATION ELEMENT USING THE SAME**

(30) Priority: 05.06.1996 RU 96110600; 05.06.1996 RU 96110601
(71) Applicant: R-Amtech International, Inc., Bellevue, Washington 98004 (US)
(72) Inventor: SVITOV, Vladislav Ivanovich, Moscow, 117133 (RU); TKACHEV, Viktor Ivanovich, Moscow, 111401 (RU); SIGOV, Alexandr Sergeevich, Moscow, 117393 (RU); DRAKIN, Nikolay Vasiljevich, Noginsky r-n, Moskovskaya obl., 146432 (RU)
(74) Representative: von Füner, Alexander, Prof.h.c. Dr.
(86) International application number: RU9700172
(87) International publication number: WO9746484

(57) **Abstract**

The present invention relates to a conformal diamond-type carbon coating having an amorphous structure, as well as to a method for producing the same. This method comprises conducting plasmic-chemical deposition of carbon onto a substrate from a flow of carbon-containing active particles and using a microwave discharge during an electron-cyclotron resonance mode. This method uses as starting reagents purified hydrocarbon pairs, the molecules of which contain atoms of chemical elements with a high electrical negativity such as oxygen or chlorine. This method allows for large variations in the chemical composition of the coating material, especially in its hydrogen contents. The diamond-type coatings thus obtained exhibit strong photoluminescence and cathodoluminescence as well as various densities and an electrical resistance higher than the value that is characteristic of natural diamond. These coatings are free from hydrogen, IR-transparent and completely absorb the visible spectrum. The conformity of the coatings obtained according to the present method makes them useful in applications onto porous filtration materials which then acquire new properties.

## Description

### Field of the Invention

The invention relates to diamond-like carbon coatings and to a method for producing such coatings from high-vacuum plasma of super high-frequency discharge (SHF) in the electron cyclotron resonance mode (ECR).

The diamond-like films, which contain diamond phase inclusions in many instances, have been used in practice mainly because of their mechanical properties and optical characteristics: hardness, wear resistance, lower coefficient of friction with the majority of structural materials, high heat conductivity, low absorption in the visible spectral area, and high refractivity. In various applications, the diamond-like films are used either as a medium for implementation of necessary structure members and devices in microchips and optically coupled electronic devices or as coatings for various uses such as protective, heat sink, decorative, and like coatings. The use of the diamond-like films in microchips and optically coupled electronic devices imposes specific requirements upon their electrical and physical properties and optical and electrical parameters such as electron emission, optical characteristics, luminescence, electric conductivity, and band gap. The degree of conformity of the diamond-like films (that ensures the exact follow-up of the microrelief of the support) and the ability to control the basic working parameters of the material without using other substances (such as doping, cladding, etc.) or sophisticated treatment (such as ion implanting, molecular beam epitaxy, vacuum sputtering, etc.) are decisive for forming structures that are based on the diamond-like films.

An important field of application for the diamond-like films is their use as protective coatings for optical devices that can function in various bands of electromagnetic radiation, which assumes that specific requirements should be imposed upon the optical characteristics of the material within the working spectral area, such as in the infrared range.

For purification of various liquids and gases from solid particles, filtering methods are used, which can have various modifications. The process basis for all these methods is the use of a filtering element that has pores dimensioned to fit a specific application. Filtering elements for purification from coarse particles may be prepared from coarse materials such as cloth, filtering paper, and the like and even from granular materials. At the same time, a vital problem is the separation of suspensions and emulsions, and fine filters with a pore size of one nanometer (molecular membranes) to a few micrometers have to be used to solve this problem. Such filtering elements are mainly prepared from polymer, ceramic, and cermet materials (including porous metals). While microporous filtering elements (which are frequently referred to as membranes) have comparatively low costs, they have a limited life because of the mechanical wear and clogging of the pores with fine contaminants during operation.

The resistance of a filtering material to the mechanical wear is especially important for oil filtering when oil is prepared for processing. The production processes that are used to displace oil from the formation (mainly with water injection) require the use of surfactants to emulsify water and to form a suspension of clay particles and solid asphaltenes. During further processing of oil, the presence of these admixtures poses very serious problems in carrying out purification from the solid inclusions, dehydration and associated desalination of oil. Filters of mechanically strong microporous materials prove irreplaceable for purification of oil products such as fuels, lubricants, and waste products as well.

### State of the Art

Known in the art are numerous methods for depositing the diamond-like films from electric discharge plasma of various types, including SHF discharge plasma in the ECR mode [1-3]. These methods involve placing the support in the active zone of a discharge (the ECR zone), applying an electrical bias to the support with a working pressure ranging from 1 to 200 Pa, and using a high temperature of the support (from 300°C to 700°C), which substantially limits the range of materials that could be used as a support for the coating application. These limitations are primarily associated with the thermal instability of many materials within the above-mentioned temperature range as well as with the direct effect of the non-equilibrium plasma in the active discharge zone on the support surface and on the coating that is being formed.

Manipulation with the composition of the starting gas mixture by adding admixtures is a fairly popular method that is used to control the process of applying carbon coatings. The admixtures play various roles: from an organometal catalyst [4] to a chemically active halogen-containing admixture [5-7], which ensure the chemical transfer of carbon in methods similar to the hot filament method. These examples do not make use of the SHF plasma of the ECR discharge, which has ill inherent advantages, and the exact metering of components added to the mixture is a very difficult technical problem.

The closest prior art is a method for producing a coating, which involves depositing the diamond-like carbon from the SHF plasma in the ECR discharge mode [8], wherein the support is positioned outside the effective range of the active plasma. This method allows the most significant disadvantage of the majority of the diamond-like film technologies to be eliminated. At the same time, additional energy has to be used, which should be applied to the support as a high-frequency voltage. The plasma is formed in the area where the electron cyclotron conditions are met due to interaction of the SHF radiation with molecules of the starting plasma-forming gas, hydrogen, which is supplied directly to the active (ECR) zone. The carbon-containing component is supplied to a zone of a flow of atoms, ions, and electrons, which has been preliminarily formed afier passing through the ECR zone. Secondary processes of dissociation and ionization result in the carbon-containing molecules being decomposed and ionized. The flow of active particles is thus enriched with carbon that forms the diamond-like film when deposited onto a support. The method for forming the plasma flow as described above requires the use of hydrogen, and gaseous hydrocarbons such as methane, propane, acetylene are used as the carbon-containing components of the starting gas mixture. As a result, the carbon material of the coating is highly hydrogenated (up to 20% of hydrogen). In this case, hydrogen is not an admixture to carbon, but rather is the basic material of the coating is a chemical compound of carbon and hydrogen, which has a variable composition.

Numerous types of the diamond-like films of various quality and composition are known [9-11], which largely differ in the physical characteristics depending on the method that is used for deposition of carbon to a solid support. The characteristic features of these films are as follows: a density of 1,500 to 2,800 kg/m³, absence of a clear-cut crystalline structure of the coating material (long-range ordering structures), weak photo luminescence and cathode luminescence, electric conductivity of 10⁻¹⁰-10⁻⁸ S/m, conductivity activation energy of about 1 eV at a temperature from 0 to 400°C, a band gap of up to 2 eV, and non-conformity that results in the ironing out of the microrelief of the support surface.

The closest prior art is a hard coating based on the diamond-like material having an amorphous structure, which contains inclusions of the diamond phase and no more than 20 atomic % of hydrogen and which is produced by the plasma chemical deposition from the SHF discharge in the ECR mode [12]. One of the disadvantages of the coating is the fact that, owing to a comparative transparence of the coating material in the visible spectral area, absorption in the infrared range is significant because of the presence of hydrogen.

The above provides the basis to believe that the conventional diamond-like films cannot completely meet the requirements imposed with microchip and optoelectronic applications, and the conventional deposition techniques do not allow conformal diamond-like carbon coatings that do not contain hydrogen, have high electronic resistance, wide band gap, high thermal sensitivity, with their electric and physical properties being easily controllable.

### Summary of the Invention

The invention solves the problem of providing a hard conformal diamond-like carbon coating with an amorphous structure, which allows submicron size non-uniformity to be produced on its surface, which has low electric conductivity and high thermal conductivity, and which does not substantially contain hydrogen to be transparent in the infrared range, while having high hardness and density that are inherent in the diamond-like film.

This is accomplished by the fact that a method for producing a hard conformal diamond-like carbon coating involves conducting plasma chemical deposition of carbon to a support from a flow of active carbon-containing particles (radicals, atoms, ions), which is formed from starting carbon-containing reagents under the effect of SHF discharge in the electron cyclotron resonance mode. The support is positioned outside the effective range of the active plasma, and the deposition is carried out by using a starting reagent in the form of vapor of pure hydrocarbons the molecules of which contain atoms of highly negative chemical elements (oxygen, chlorine, etc.).

Another object of the invention is to provide a hard conformal diamond-like carbon coating with an amorphous structure, which contains inclusions of the diamond phase in which the diamond-like material is pure carbon, i.e., an elemental substance. The coating according to the invention has high hardness and density and is practically opaque for the visible-range light, which does not show any significant absorption in the infrared range in the 2 to 25 µm waveband.

The high conformity of the coating allows a porous material to be produced, having modified properties, e.g., improved wear resistance. It is, therefore, a third object of the invention to provide a porous filtering material in which a hard conformal diamond-like carbon coating, which is produced according to claim 1, is deposited to a porous support, the coating having high mechanical strength and hydrophobicity.

The method according to the invention involves depositing a carbon coating from the SHF discharge plasma in the ECR mode by conducting the plasma decomposition of vapor of hydrocarbons containing carbon, hydrogen, and electrically negative components with a pressure in the working chamber that does not exceed 1 Pa to a support that is positioned outside the ECR zone, with an SHF power flow density ranging from 2 to 50 W/m² (from 0.2 to 5 W/cm2 in generally adopted units). The ECR mode is established in the SHF discharge plasma in a magnetic field. When the SHF radiation at the frequency of 2.45 GHz is used at the points where the magnetic induction is at 875 H, the frequency of the electron circulation around the direction of the magnetic field coincides with the frequency of the SHF radiation. As a result, the electrons will be accelerated to superthermal energy. Those are exactly the conditions for establishing the electron cyclotron resonance. Putting an SHF wave-guide (which also functions as a plasmatron) ensures the desired configuration of the magnetic field into a specially designed solenoid. The position of a zone in which the condition for establishing the ECR is met by the solenoid parameters and is controlled by the direct measurements of the magnetic induction in tuning up the process chamber. For efficient initiation of the SHF discharge, it is required that the ECR zone coincide with the antinode of the standing wave. When the support is positioned in the ECR zone, it causes changes in the discharge conditions. In addition, an active plasma area emerges in the ECR zone, which has a high-energy electron component that reacts with the support surface to decelerate growth of the carbon field and to cause material changes in its properties. To avoid this, the support is positioned outside the ECR zone. This division into the plasma-forming zone (into the areas of excitation, decomposition, and ionization of the gas) and the coating-forming zone prevents the direct effect of the high-energy electron component on the surface of the support and of the coating that is being formed and protects the support against the intensive electromagnetic radiation (by screening the support with the discharge zone). An increase in the distance from the support to the ECR zone results in the radial gradients of the flow being leveled out by the moment interaction between the active particles and the support surface, with the support temperature decreasing during the film deposition process. At the same time, the rate of film growth decreases owing to relaxation of the active particles both on the reactor walls and at collisions of the particles before they reach the support surface. The presence of components that contain atoms of active nonmetals (highly electrically negative chemical elements) in the starting reagents results in a material reduction in the concentration of free electrons, thus contributing to the deposition of a high-quality conformal carbon film. The distance at which the support shall be positioned with respect to the ECR zone for obtaining the preset conditions for carbon deposition depends on the linear velocity of the active particle flow and on kinetics of the relaxation processes. To determine this distance in a general case, a complicated kinetic problem has to be resolved, taking into account the processes of diffusion of the reagents in the radial direction, the volumetric recombination of the active particles, and the positive mass transfer in the directional flow of the active particles between the ECR zone and the support. It is, however, important, that a decrease in the rate of film growth is accompanied by an increase in uniformity of its deposition and in its conformity. The direct tests showed that when low pressures (0.01 to 1 Pa) were used, the distance from the ECR zone to the support can be as long as dozens of centimeters, yet the film would grow at a remarkable rate.

The above-described method for forming a flow of the active particles allows vapor of various pure hydrocarbons to be used as a starting reagent rather than their mixtures. To lower the concentration of free electrons in the flow and to control the composition of the carbon-coating material through reactions of carbon and hydrocarbon with atoms of highly electrically negative elements, we used various oxygen-containing hydrocarbons. High-quality optically transparent coatings were produced by using acetone (C:H:O atomic ratio = 3:6:1) and propanol-2 (C:H:O atomic ratio = 3:8:1). At the same time, the presence of atoms of highly electrically negative elements in the plasma, which are capable of effectively chemically binding hydrogen, eliminates hydrogenation of the carbon-coating material. We used various chlorinated hydrocarbons to bring a solution to this problem. It has been found that with the use of dichloromethane (the atomic ratio C:H:Cl = 1:2:2), a diamond-like carbonaceous material, which does not contain hydrogen, could be produced.

### Brief Description of the Drawings

Fig. 1 shows the photo luminescence of carbon coatings produced from the ECR discharge plasma;
Fig. 2 shows the cathode luminescence spectra of a carbon coating and of a diamond composite;
Fig. 3 shows the Raman spectrum of a hydrogen-free diamond-like carbon coatings;
Fig. 4 shows the infrared spectra of carbon coatings;
Fig. 5 shows the temperature behavior of electric conductivity of the carbon films and natural diamond;
Fig. 6 is an electron microscope photograph of the transversal cleavage of a specimen of the diamond-like carbon coating on silicon.

### Embodiment of the Invention

The method according to the invention was used to prepare a series of test specimens of coatings on silicon, optical glasses, and porous cermet membranes (see Example D). A support was attached to a movable support holder that allowed the support to be moved around within the interior of a processing unit. The unit was sealed off and evacuated to a pressure of 2·10⁻⁸ Pa. A working gas such as acetone vapor (Example A), isopropyl alcohol (Example B), or dichloromethane (Example C) was admitted to the system with a flow rate that ensured a pressure of 0.3 Pa with a constant evacuation rate. This technique allowed a directional flow of particles to be established through the ECR zone toward the support and then to the evacuation system. The SHF discharge was then fired. The support was moved and positioned at a preset distance. The rate of film growth that was obtained by varying the test conditions with the distance from the support to the ECR zone of 65 mm is 6 µm/h in the conventional units (compared to 1-2 µm/h for conventional prior art methods).

The coatings that were obtained by using the above-described method were examined by the Raman spectroscopy and infrared spectroscopy, using the Fourier method (Fourier infrared spectroscopy), cathode luminescence, optical spectroscopy in the visible and UV ranges, as well as by plotting the electric conductivity versus temperature.

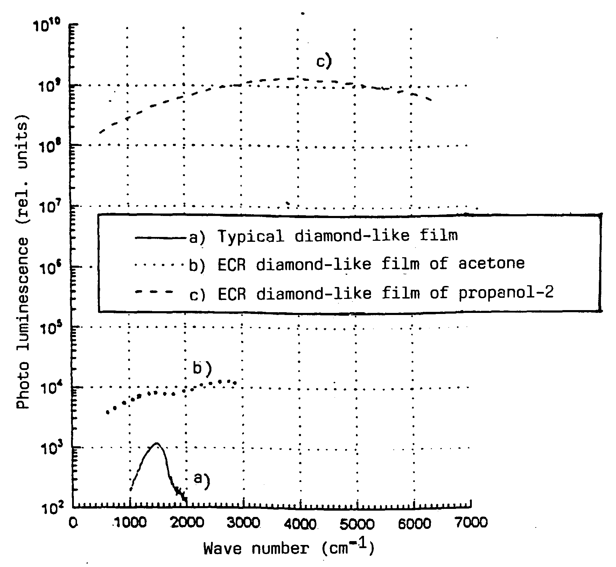

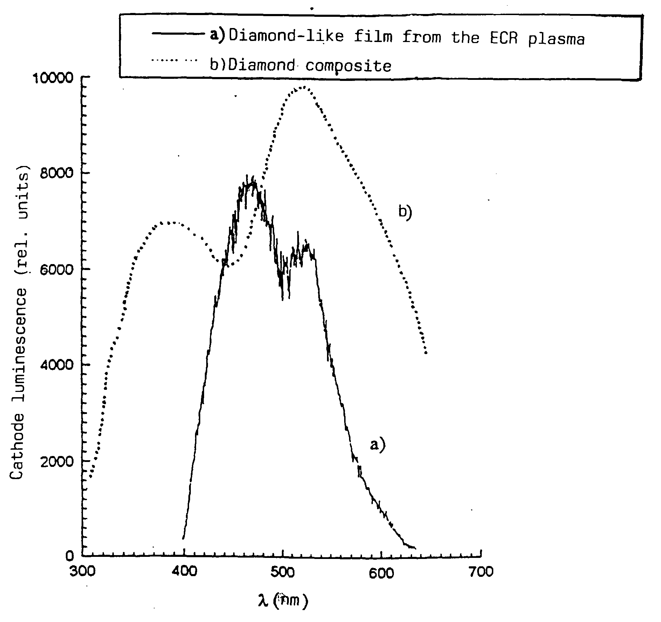

It is known that the generally recognized sign of the presence of the diamond phase in the diamond-like films is the Raman dispersion peak at 1332 cm⁻¹, but we could not identify this peak in Examples A and B against the background of a very strong photo luminescence. The same was true for a coating produced by the prior art method [8]. It should be, however, noted that luminescence was unusually high in the case of this method. Fig. 1 shows the combination dispersion spectra (Raman spectra) for the diamond-like coatings typical of the conventional deposition technique (1a) and for two coatings that were produced by using the above-described technique (1b and 1c). The intensities of the spectra were adjusted to bring them to the comparable measurement conditions. The results show that the carbon coatings produced by using the method according to the invention had such a strong photo luminescence that it was not possible to observe the combination dispersion lines. (It should be noted that the intensity for spectrum 1c was 2.5·10⁶ times as high as the natural level for spectrum 1a.) The cathode luminescence data can be used as an indicator of the presence of the diamond carbon in the coating (Fig. 2). The cathode luminescence spectrum of the diamond-like coating that was studied had a peak coinciding with the cathode luminescence peak in the spectrum of the diamond composite taken for the sake of comparison (compare Figs. 2a and 2b).

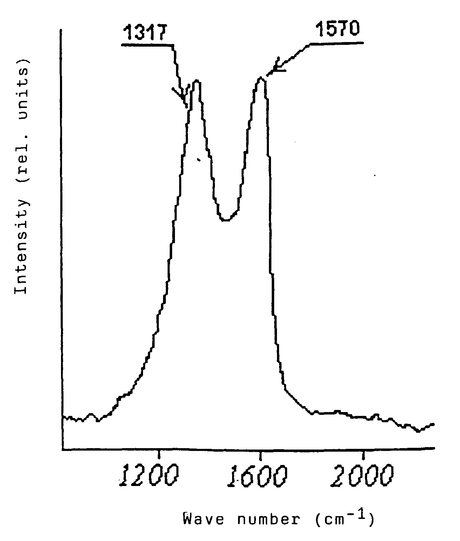

Fig. 3 shows the combination dispersion spectrum (Raman spectrum) for a coating that was produced by using the method according to the invention with a pressure of 0.3 Pa from plasma of dichloromethane vapor (Example C). The spectrum has a band typical of the diamond-like film at 1570cm⁻¹, but there is also a peak at 1317 cm⁻¹. It is known that the Raman dispersion peak at 1332 cm⁻¹ is characteristic of pure diamond, and oriented graphite (G-graphite) gives a band at 180 cm⁻¹. The above data represent the qualitative evidence of the presence of sp³-hybridized carbon (typical of the diamond phase) in the resulting carbon coating material. It is not quite correct to evaluate the ratio of the quantities of the "diamond and non-diamond" carbon by the Raman spectra of the diamond-like films based on the ratio of the peaks at 1317 and 1570 cm⁻¹ as it is often done by some scientists. This can be explained by certain disputable physical considerations that cannot be discussed in detail here. The ratio that is obtained from the data given in Fig. 3 shows that the percentage of sp³-hybridized carbon in the coating material is about 45%. This percentage is not, however, a one-to-one indicator of the concentration of the diamond phase. It is not possible to determine its accurate value by using this approach.

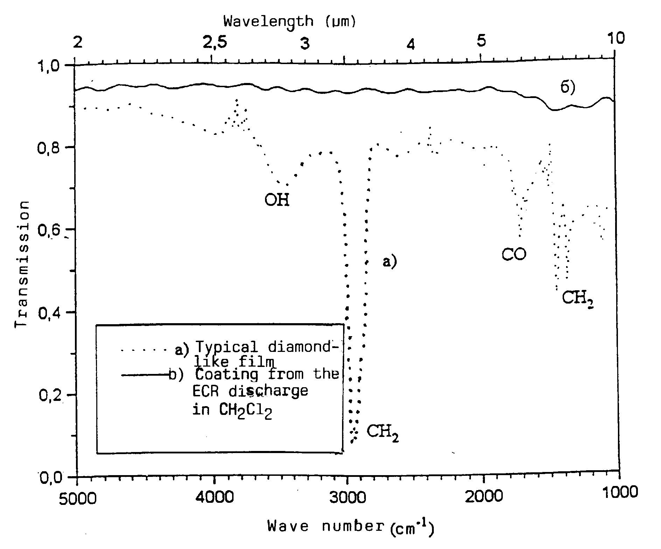

The composition of the resulting carbon coating was examined by the Fourier infrared spectroscopy. The respective spectra are given in Fig. 4. This Figure shows a portion of a spectrum in which the absorption bands of the basic functional groups available in the material of the carbon coating. These data shows that, unlike the typical diamond-like films (Examples A and B), the coatings produced from dichloromethane (Example C) do not have functional groups CH₂, CO, and OH. This results in the absence of an appreciable absorption within the range of 2 to 25 µm that was normally used for detecting infrared radiation. There is substantially no transmission in the visible area, and the resulting coating can be regarded as black. The gravimetry shows that the density of the diamond-like material of the coating in Example C is about 2900 kg/m³ (graphite density is 2150 kg/m³ and diamond density is 3300 kg/m³). It is difficult to measure hardness of the carbon coatings because they are poorly adhesive to the majority of structural materials. We managed to obtain the data on the strength characteristics of the deposited coatings under mechanical loading by using special adhesion enhancement methods that do not have material bearing on this invention. These methods allow the lower limit of hardness for the coating material, which depends on the mechanical strength of the support, to be assessed. The data obtained for coatings on hard metals attest to the fact that hardness of the diamond-like carbon coatings, which is formed by the method according to the invention from the SHF discharge in the ECR mode, is higher than 25 GPa.

The band gap for the carbonaceous material that forms the coating was determined by the size of the fringe of the optical absorption of the coating based on the optical spectroscopy. The band gap was as large as 3.5 eV. This band gap allows the blue glow to be produced in optically coupled devices incorporating the diamond-like coatings. The problem of providing a blue light-emitting element is one of the vital problems in optoelectronics today.

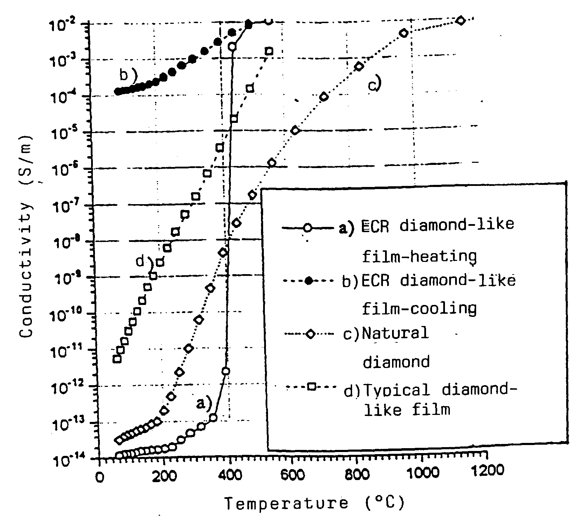

The temperature behavior of the electric conductivity of the resulting diamond-like coating is shown in Fig. 5 (a and b). For the sake of comparison, Fig. 5c shows the data for a natural diamond. It can be seen that the diamond-like coating has the electric conductivity of 10⁻¹⁴ S/m at room temperature, which is one order lower than similar diamond-like coatings (Fig. 5d). The most important thing here is that the electric conductivity materially increases in the area of 350°C to 450°C (an increase by 11 orders!), with a temperature coefficient of more than 10⁸K⁻¹. Bearing in mind that this value for diamond does not exceed 10⁶K⁻¹ (the same values are also typical of the diamond-like coatings produced by using prior art methods of Fig. 5d), it would be easy to estimate that the temperature coefficient for the electric conductivity of the coating that is produced by the method according to the invention is more than two orders higher than that for diamond. This allows the resulting carbonaceous material to be used for recording thermal radiation.

The data given in Fig. 5 (a and b) shows that when the coating is heated above 450°C, its electrical conductivity increases irreversibly to 0.01 S/m. This allows the electric and physical parameters of the resulting carbonaceous material to be controlled within a broad range by using mild enough thermal effects such as an exposure to a lowpower laser beam. This offers an opportunity to use an inexpensive and simple laser beam lithographic technique for forming passive and potentially active structural members of microelectronic devices.

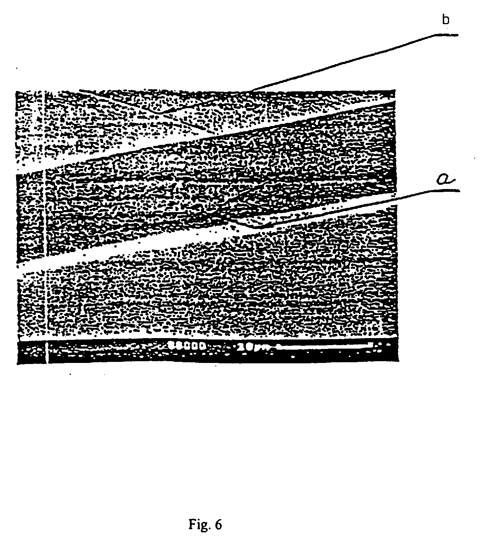

An electron microphotograph of the transversal cleavage of the support having the diamond-like coating produced by the method according to the invention is shown in Fig. 6. The photograph clearly shows high conformity of the film: a submicron scratch in the support surface is reproduced on the surface of a 10-micron film substantially without distortions. This attests to the fact that a microrelief of the support can be transferred to the surface of the coating that covers the support, which is important for certain applications, e.g., in forming active structures for microchip elements.

This high degree of conformity of the coating allows the coating to be applied to a porous material to modiX properties of the material, primarily its wear resistance. A filtering material may be covered with a film of the diamond-like film that has high mechanical strength and also hydrophobicity. It should be also noted that when the method for deposition of the diamond-like film from the SHF discharge plasma is used, a thin-film diamond-like coating could be produced not only on the visible surface but also within the microscopic pores. As a result, a filtering element made of a porous material having the diamond-like coating is imparted high resistance to the mechanical wear. Moreover, high hydrophobicity of the coating assures an additional technical result, which, in certain applications, can be decisive. For instance, a filter having such a filtering element can let through non-polar liquids (e.g., oil and oil products) and still retain and separate water that is emulsified in these liquids.

The following example of a porous material can be cited.

For metal membranes of stainless steel, deposition of a carbonaceous film coating of CH₂Cl₂ (Example D) lowers the overall transmission capacity of the membrane, while at the same time, lowering significantly the transmission capacity for water and enhancing the wear resistance of the membrane substantially by one order. Comparison of the characteristics of the porous filtering material is given in Table 1.

**Table 1**

| Comparison of the characteristics of the porous filtering material | | | |
|---|---|---|---|
| Membrane coating | Without a coating | With the coating | Relative change, (+/-), % |
| Maximum pore diameter, Dₘₐₓ, µm | 2.6 | 2.27 | -12.692 |
| Average pore diameter, D_{av.}, µm | 1.9 | 1.64 | -13.684 |
| Water transmission under a gauge pressure of 2 atm QH₂O (ΔP=2 atm), 1/m²·h | 38,000 | 21,300 | 43.95 |
| Attrition (loss of material), mg/cm² | 20 | 2 | 90 |
| Gas permeability, % | 100 | 80 | -20 |

In addition, for metal membranes of stainless steel with a rutile coating (double-layer membranes), which have the size of the pores that is smaller than the size of the pores in purely metal membranes, depositing a coating results in stronger changes in certain characteristics. Thus depositing a film coating of CH₂Cl₂ (Example E) to these membranes results in the water transmission capacity being reduced substantially to zero under a gage pressure of more than 3 atm. The overall reduction of the transmission capacity of the membrane remains within 15 to 20% similar to the case of purely metal single-layer membranes. The order of the wear resistance of the membrane is increased by one order as well. Comparison of the characteristics of the porous filtering material that was produced by the method according to the invention is given in Table 2.

The analysis of the data given in Tables 1 and 2 shows that the porous filtering material has the enhanced wear resistance. In addition, the use of this material results in a lower water transmission capacity, while the transmission capacity in terms of other components (overall transmission) decreases by less than one quarter. The effect of the film coating on the membrane capacity to let water through is significantly reduced when the average size of the pores of the filtering material decreases.

**Table 2**

| Comparison of the characteristics of membranes of porous filtering material | | | |
|---|---|---|---|
| Membrane coating | Without a coating | With the coating | Relative change, (+/-), % |
| Maximum pore diameter, Dₘₐₓ, µm | _* | 0.8 | - |
| Average pore diameter, D_{av.}, µm | 0.1 | less than 0.09 | more than -10 |
| Water transmission under a gauge pressure of 0.5 atm QH₂O (ΔP=0.5 atm), 1/m²·h | 2,500 | None found | 100 |
| Water transmission under a gauge pressure of 3 atm QH₂O (ΔAP=3 atm), 1/m²·h | _* | None found | _* |
| Attrition (loss of material), mg/cm² | 70 to 110 | 7 | 90 to 93.64 |
| Gas permeability, % | 100 | 85 | -15 |

| | | | |
|---|---|---|---|
| * The parameter was not determined. | | | |

### REFERENCES

1. Kawarada et al., Large Area Chemical Vapor Deposition of Diamond Particles and Films Using Magneto-Microwave plasma, Jap. Journ. of Appl. Phys., 1987, V. 26, No 6, p. 1032.
2. Japanese Patent Application No. 4-329879, Cl. C23C 16/26, CO1B31/06, C23C16/50, HO1L21/205, Pat. Abstr. Of Jap., 1993, V. 17, No. 1990.
3. Dusek et al. Influence of Electron Cyclotron Resonance Microwave Plasma on Growth and Properties of Diamond-like Carbon Deposited onto r.f. biased Substrates, Diamond and Relat. Mater., 1993, No 2, p. 397.
4. US Patent No. 4,871,581, Cl. BO5D 3/06, 1989.
5. Patents Abstracts of Japan, C-1136, 1993, Vol. 17, No. 655.
6. Int. Appl. Published under PCT, WO 92/19791, PCT/US92/03570, 1992.
7. Int. Appl. Published under PCT, WO 96/02685, PCT/GB/01680, 1996.
8. US Patent No. 5,427,827, Cl. BO5D 3/06; C23C 16/26, 1995.
9. Dusek and J. Musil. Microwave Plasmas in Surface Treatment Technologies, Czech. J. Phys., 1990, No 11, p. 1193.
10. Yoshikawa, N. Nagai, G. Katagiri, H. Ishida and A. Ishitani. Raman Spectra of Diamondlike Amorphous Carbon Films. Proc. Jap. New Diamond Forum, Kobe, Japan, 1988, P3-20.
11. Meyerson, F.W. Smith. Electrical and Optical properties of Hydrogenated Amorphous Carbon Films, J. Non-Cryst. Sol., 1980, No 35/36, p. 435.
12. US Patent No. 4,935,303, Cl. B32B 9/00; BO5D 3/06, 1990.

## Claims

1. A method for producing a hard conformal diamond-like carbon coating, comprising conducting the plasma chemical deposition of carbon from a flow of carbon-containing active particles, which is formed in the plasma of the SHF discharge in the electron cyclotron resonance mode from a starting carbon-containing reagent, to a support that is positioned outside the active zone of the plasma, characterized by the fact that the starting reagents comprise vapor of pure hydrocarbons the molecules of which contain atoms of highly electrically negative chemical elements.

2. The method of claim 1, characterized in that the starting reagent comprises vapor of oxygen-containing hydrocarbons.

3. The method of claim 1, characterized in that the starting reagent comprises vapor of halogen-containing hydrocarbons.

4. The method of claim 1, characterized in that the starting reagent comprises vapor of dichloromethane.

5. A hard conformal diamond-like carbon coating based on the diamond-like material prepared according to claim 1 and claims 2 through 4, characterized in that it has an amorphous structure and contains inclusions of the diamond phase, the diamond-like material comprising pure carbon.

6. The hard conformal diamond-like coating according to claim 5, characterized in that it exhibits luminescence in the visible light range.

7. The hard conformal diamond-like coating according to claim 5, characterized in that it has the electric resistance that is higher than the electric resistance of natural diamond and has an anomalous temperature behavior of the electric resistance.

8. The hard conformal diamond-like coating according to claim 5, characterized in that it is transparent in the infrared range from 2 to 25 µm.

9. A porous filtering material, characterized in that it has a porous support to which the hard conformal diamond-like carbon coating of claim 1 is applied.

10. The porous filtering material of claim 9, characterized in that the porous support to which the hard conformal diamond-like carbon coating is ceramic.

11. The porous filtering material of claim 9, characterized in that the porous support to which the hard conformal diamond-like carbon coating is ceramic.

12. The porous filtering material of claim 9, characterized in that the porous support to which the hard conformal diamond-like carbon coating is mineral ceramic.

13. The porous filtering material of claim 9, characterized in that the porous support to which the hard conformal diamond-like carbon coating is cellulose and/or a cellulose-containing material.
